# EUROPÄISCHE PATENTSCHRIFT

(11) **EP 3 280 577 B1**
(45) Veröffentlichungstag und Bekanntmachung des Hinweises auf die Patenterteilung: **14.10.2020**
(21) Anmeldenummer: 16719224.4
(22) Anmeldetag: 07.04.2016
(51) Int. Cl.: B28D 1/22, B81C 1/00

(54) **VERFAHREN ZUR MATERIALSPARENDEN WAFERHERSTELLUNG**
METHOD FOR THE MATERIAL-SAVING PRODUCTION OF WAFERS
PROCÉDÉ DE FABRICATION DE TRANCHES AVEC ECONOMIE DE MATERIAUX

(30) Priorität: 09.04.2015 DE 102015004601
(43) Veröffentlichungstag der Anmeldung: 14.02.2018
(73) Patentinhaber: Siltectra GmbH, 01099 Dresden (DE)
(72) Erfinder: SCHILLING, Franz, 01454 Radeberg (DE); DRESCHER, Wolfram, 01099 Dresden (DE); RICHTER, Jan, 01277 Dresden (DE)
(74) Vertreter: Westphal, Mussgnug & Partner Patentanwälte mbB
(86) Internationale Anmeldenummer: PCT/EP2016/057632
(87) Internationale Veröffentlichungsnummer: WO 2016/162428

(56) Entgegenhaltungen:
- WO-A1-2014/064606
- DE-A1-102013 007 673
- US-A1- 2010 230 803
- US-A1- 2014 038 392

## Beschreibung

Die vorliegende Erfindung bezieht sich auf ein Verfahren zum Herstellen einer Mehrschichtanordnung gemäß Anspruch 1.

In vielen technischen Bereichen (z.B. Mikroelektronik- oder Photovoltaiktechnologie) werden Materialien, wie z.B. Silizium, Germanium oder Saphir, häufig in der Form dünner Scheiben und Platten (so genannte Wafer) gebraucht. Standardmäßig werden solche Wafer derzeit durch Sägen aus einem Ingot hergestellt, wobei relativ große Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafern für Solarzellen fast 50% des eingesetzten Materials als "kerf-loss" verloren. Weltweit gesehen entspricht dies einem jährlichen Verlust von über 2 Milliarden Euro. Da die Kosten des Wafers den größten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in WO 2009/061353 A2 und WO 2010/072675 A2 beschrieben sind, wo zum Erzeugen dieser Spannungen eine auf das Werkstück aufgetragene Polymerschicht verwendet wird. Das Dokument US 2014/038392 A1 offenbart ein Verfahren mit den Schritten Bereitstellen eines Spendersubstrats zum Abtrennen einer Festkörperschicht, Erzeugen von Modifikationen in dem Spendersubstrat zum Vorgeben eines Rissverlaufs, Bereitstellen eines Trägersubstrats zum Aufnehmen der Festkörperschicht, Anbonden des Trägersubstrats mittels einer Bondingschicht an dem Spendersubstrat, wobei das Trägersubstrat zur Erhöhung der mechanischen Festigkeit der abzutrennenden Festkörperschicht für die Weiterverarbeitung vorgesehen ist, thermisches Beaufschlagen zum Erzeugen von Spannungen in dem Spendersubstrat, wobei durch die Spannungserzeugung ein Riss ausgelöst wird, der sich entlang des vorgegebenen Rissverlaufs zum Abtrennen der Festkörperschicht vom Spendersubstrat ausbreitet, so dass sich die Festkörperschicht mit dem angebondeten Trägersubstrat abtrennt.

Ferner entstehen in bekannten Fabriken zur Waferverarbeitung erhebliche Materialverluste, da die bereitgestellten Wafer zur Handhabung in den standardisierten Prozessen einer solchen Fabrik jeweils mit einer Standarddicke vorliegen müssen. Die Zieldicke wird dann vor Ort durch eine spanende Bearbeitung der Wafer erzielt. Die spanende Bearbeitung hat jedoch erhebliche Nachteile. Zum einen zerstört sie das zu entfernende Material und zum anderen wird der verbleibende Waferanteil erheblichen mechanischen Belastungen ausgesetzt. Spanende Bearbeitungsverfahren bewirken ferner, dass Wärme und Staub entsteht. Weiterhin bewirken spanende Bearbeitungsverfahren in der Regel eine Riefenbildung, durch welche die Oberflächengüte des Wafers beeinträchtigt wird.

Es ist somit Aufgabe der vorliegenden Erfindung ein alternatives Verfahren bereitzustellen, das gegenüber den bekannten Verfahren eine Ressourceneinsparung und/oder eine Qualitätsverbesserung ermöglicht.

Die zuvor genannte Aufgabe wird erfindungsgemäß durch ein Verfahren zum Herstellen einer Mehrschichtanordnung gelöst. Das erfindungsgemäße Verfahren umfasst bevorzugt mindestens die Schritte des Bereitstellens eines Spendersubstrats zum Abtrennen einer Festkörperschicht, des Bereitstellens eines Trägersubstrats zum Aufnehmen der Festkörperschicht, des Erzeugens von Modifikationen, insbesondere mittels LASER-Strahlen, in dem Spendersubstrat zum Vorgeben eines Rissverlaufs, des Anbondens des Trägersubstrats mittels einer Bondingschicht an dem Spendersubstrat, wobei das Trägersubstrat zur Erhöhung der mechanischen Festigkeit der abzutrennenden Festkörperschicht für die Weiterverarbeitung vorgesehen ist, des Anordnens oder Erzeugens einer Spannungserzeugungsschicht an dem Trägersubstrat und des thermischen Beaufschlagens der Spannungserzeugungsschicht zum Erzeugen von Spannungen in dem Spendersubstrat, wobei durch die Spannungserzeugung ein Riss ausgelöst wird, der sich entlang des vorgegebenen Rissverlaufs zum Abtrennen der Festkörperschicht vom Spendersubstrat ausbreitet, so dass sich die Festkörperschicht mit dem angebondeten Trägersubstrat abtrennt.

Diese Lösung ist vorteilhaft, da die gewünschte Festkörperschicht stabil und somit transportierbar und bearbeitbar auf einem Trägersubstrat angeordnet ist.

Weitere bevorzugte Ausführungsformen sind Gegenstand der nachfolgenden Beschreibungsteile und/oder der Unteransprüche.

Die Bondingschicht verbindet gemäß einer weiteren bevorzugten Ausführungsform der vorliegenden Erfindung die Festkörperschicht und das Trägersubstrat stoffschlüssig miteinander und mittels Strahlung, insbesondere Laserstrahlung oder UV-Strahlung, oder einer fließfähigen Substanz, insbesondere einer flüssigen Lösung, ist die Bondingschicht zerstörbar. Diese Ausführungsform ist vorteilhaft, da zum einen eine stabile stoffschlüssige Bindung geschaffen wird, die bei Bedarf, insbesondere zum Ablösend der Festkörperschicht von dem Trägersubstrat, z.B. chemisch oder mittels Strahlung geschwächt, insbesondere zerstört, werden kann. Die Bondingschicht ist insbesondere derart konfiguriert, dass sie durch die mittels der Spannungserzeugungsschicht erzeugten Spannungen nicht zerstört wird.

Gemäß einer weiteren bevorzugten Ausführungsform der vorliegenden Erfindung wird nach dem Abtrennen der Festkörperschicht von dem Festkörper die Spannungserzeugungsschicht von dem Trägersubstrat entfernt. Diese Ausführungsform ist vorteilhaft, da dadurch das Gewicht und die Dicke der Mehrschichtanordnung reduziert werden. Insbesondere die Dickenreduzierung ermöglicht eine verbesserte Einbindung der Mehrschichtanordnung in nachgelagerte Bearbeitungsprozesse. Das entfernte Polymer wird bevorzugt zur Wiederverwendung aufbereitet oder entsorgt. Zusätzlich oder alternativ ist denkbar, dass eine Materialschicht, insbesondere epitaktisch, auf der Festkörperschicht erzeugt wird. Bevorzugt erfolgt vor der Erzeugung der Materialschicht eine strukturelle Schwächung des Trägersubstrats und/oder der Festkörperschicht. Als strukturelle Schwächung ist hierbei z.B. das Entfernen oder Abtragen oder Zerstören von Material der jeweiligen Schicht zu verstehen. Im Sinne der Erfindung kann somit bevorzugt entlang vorgegebener bzw. definierter Bereiche, insbesondere Linien, abschnittsweise eine Perforation der jeweiligen Schicht, insbesondere mittels Laserstrahle oder spanender Bearbeitung oder Ätzen, bewirkt werden. Zusätzlich oder alternativ kann entlang der vorgegebenen bzw. definierten Bereiche, insbesondere Linien, die jeweilige Schicht teilweise oder vollständig abgetragen werden. D.h. es können grabenartige Vertiefungen erzeugt werden. Diese Ausgestaltung ist vorteilhaft, da die strukturellen Schwächungen in Analogie zu Dehnungsfugen bei einer Temperierung der Mehrschichtanordnung das Entstehen großer Spannungen verhindert. Dies ist ferner vorteilhaft, da dadurch ein ungewolltes Verbiegen oder Zerbrechen der Mehrschichtanordnung verhindert wird. Eine Temperierung der Mehrschichtanordnung kann dabei z.B. beim Erzeugen oder Anordnen einer weiteren Materialschicht an der Festkörperschicht oder an der Trägerschicht erforderlich sein. So treten z.B. bei einer epitaktischen Erzeugung einer Materialschicht Temperaturen von mehr als 400°C oder von mehr als 600°C oder von mehr als 800°C oder von mehr als 1000°C auf. Die vorgegebenen bzw. definierten Bereiche geben bevorzugt Linien vor, wobei besonders bevorzugt eine erste Mehrzahl an Linien parallel zueinander vorgesehen ist und eine zweite Mehrzahl an Linien ebenfalls paralle zueinander vorgesehen ist. Bevorzugt ist die erste Anzahl, insbesondere Mehrzahl, an Linien geneigt, insbesondere orthogonal, zu der zweiten Anzahl, insbesondere Mehrzahl, an Linien ausgerichtet. Somit bilden die vorgegebenen bzw. definierten Bereiche bevorzugt ein gitterartiges Muster aus. Einzelne oder mehrere der ersten Anzahl an Linien können dabei einzelne oder mehrere der zweiten Anzahl an Linien schneiden. Jede Anzahl repräsentiert hierbei bevorzugt eine oder mehr als eine Linie. Bevorzugt begrenzen die Anteile der ersten Mehrzahl und die Anteile der zweiten Mehrzahl Flächenanteile, insbesondere rechteckige oder quadratische Flächenanteile, der jeweiligen Schicht, insbesondere der Festkörperschicht. Bevorzugt korrespondiert bzw. entspricht die Länge eines solchen Flächenanteils der Länge einer oder mehrerer aus diesem Flächenanteil herauszutrennender bzw. herauszuarbeitender Einheit/en, insbesondere Chip bzw. Chips. Bevorzugt korrespondiert bzw. entspricht die Breite eines solchen Flächenanteils der Breite einer oder mehrerer aus diesem Flächenanteil herauszutrennender bzw. herauszuarbeitender Einheit/en, insbesondere Chip bzw. Chips.

Das bereitgestellte Trägersubstrat wird gemäß einer weiteren bevorzugten Ausführungsform der vorliegenden Erfindung mehrfach zum Erzeugen einer Mehrschichtanordnung verwendet, wobei die Festkörperschicht vor der erneuten Bereitstellung von dem Trägersubstrat entfernt wird und das Trägersubstrat vor der erneuten Bereitstellung aufbereitet, insbesondere poliert, wird. Diese Ausführungsform ist vorteilhaft, da durch die Wiederverwendung des Trägersubstrats in erheblichem Ausmaß Materialverluste reduziert werden.

Gemäß einer weiteren bevorzugten Ausführungsform der vorliegenden Erfindung wird vor dem Anordnen oder Erzeugen einer Spannungserzeugungsschicht an dem Trägersubstrat eine Opferschicht auf dem Trägersubstrat angeordnet oder erzeugt, wobei die Spannungserzeugungsschicht an der Opferschicht angeordnet oder erzeugt wird. Diese Ausführungsform ist vorteilhaft, da durch die Opferschicht bevorzugt eine Haftvermittlung bewirkt wird und/oder das Ablösen der Spannungserzeugungsschicht von dem Trägersubstrat erleichtert wird.

Die Spannungserzeugungsschicht weist gemäß einer weiteren bevorzugten Ausführungsform der vorliegenden Erfindung ein Polymer, insbesondere Polydimethylsiloxan (PDMS), auf oder besteht daraus, wobei die thermische Beaufschlagung bevorzugt derart erfolgt, dass das Polymer einen Glasübergang erfährt, wobei die Spannungserzeugungsschicht, insbesondere mittels flüssigem Stickstoff, auf eine Temperatur unterhalb der Raumtemperatur oder unterhalb von 0°C oder unterhalb von -50°C oder unterhalb von -100°C oder unterhalb von -110°C, insbesondere auf eine Temperatur unterhalb der Glasübergangstemperatur der Spannungserzeugungsschicht, temperiert wird.

Diese Ausführungsform ist vorteilhaft, da erkannt wurde, dass durch die thermische Beaufschlagung der Spannungserzeugungsschicht, insbesondere durch Ausnutzung der beim Glasübergang auftretenden Eigenschaftsveränderungen des Materials der Spannungserzeugungsschicht, die zur Rissauslösung und Rissführung erforderlichen Kräfte in einem Spendersubstrat erzeugt werden können.

Gemäß einer weiteren bevorzugten Ausführungsform der vorliegenden Erfindung sind die Modifikationen lokale Risse im Kristallgitter und/oder in eine andere Phase überführte Materialanteile und/oder die Modifikationen werden mittels über eine äußere Oberfläche des Spendersubstrats, insbesondere an der das Trägersubstrat angeordnet wird, eingeleitete LASER-Strahlen mindestens einer LASER-Einrichtung erzeugt. Diese Ausführungsform ist vorteilhaft, da durch die Modifikationen die Rissführung bzw. der Rissverlauf sehr genau vorgebbar ist.

Die LASER-Einrichtung ist gemäß einer weiteren bevorzugten Ausführungsform der vorliegenden Erfindung zum Bereitstellen der in das Spendersubstrat einzubringenden LASER-Strahlen derart konfiguriert, dass die von ihr ausgestrahlten LASER-Strahlen die Modifikationen an vorbestimmten Orten innerhalb des Spendersubstrats erzeugen, wobei die LASER-Einrichtung bevorzugt derart eingestellt wird, dass die von ihr ausgestrahlten LASER-Strahlen zum Erzeugen der Modifikationen auf eine definierte Tiefe von weniger als 200µm, bevorzugt von weniger als 150µm und weiter bevorzugt von weniger als 100µm und besonders bevorzugt von weniger als 60µm oder von weniger als 50µm in das Spendersubstrat eindringen, wobei die LASER-Einrichtung eine Pulsdauer von unter 10 ps bevorzugt von unter 1 ps und besonders bevorzugt von unter 500 fs aufweist.

Weiterhin ist denkbar, dass die Modifikationen erst nach der Anbringung des Trägersubstrats an dem Spendersubstrat erzeugt werden. Bevorzugt ist in diesem Fall das Trägersubstrat für die Strahlung transparent oder teilweise transparent ausgebildet.

Die LASER-Einrichtung umfasst gemäß einer weiteren bevorzugten Ausführungsform der vorliegenden Erfindung einen Femtosekunden-LASER (fs-LASER) und die Energie der LASER-Strahlen des fs-LASER wird bevorzugt derart gewählt, dass die Schädigungsausbreitung einer jeden Modifikation in der Nutzschicht und/oder der Opferschicht kleiner als 3 mal die Rayleighlänge, bevorzugt kleiner als die Rayleighlänge und besonders bevorzugt kleiner ein Drittel mal die Rayleighlänge ist und/oder die Wellenlänge der LASER-Strahlen des fs-LASER wird derart gewählt, dass die Absorption der Nutzschicht und/oder der Opferschicht kleiner als 10cm⁻¹ und bevorzugt kleiner als 1cm⁻¹ und besonders bevorzugt kleiner als 0,1cm⁻¹ ist und/oder die einzelnen Modifikationen ergeben sich jeweils in Folge einer von dem fs-LASER bewirkten multi-photonen Anregung.

Vor einer erneuten Einbringung von LASER-Strahlen zur Erzeugung von Modifikationen in dem Spendersubstrat und/oder vor einer erneuten Anbringung des Trägersubstrats oder eines anderen Trägersubstrats an dem Spendersubstrat wird gemäß einer weiteren bevorzugten Ausführungsform der vorliegenden Erfindung die durch die Abtrennung der Festkörperschicht freigelegte Oberfläche des Spendersubstrats behandelt, insbesondere aufbereitet, bevorzugt geglättet, insbesondere poliert. Diese Ausführungsform ist vorteilhaft, da durch die Rissführung der Festkörper im Bereich der Modifikationen, insbesondere die Modifikationen durchdringend, gespalten wird, wodurch die nicht abgetrennten Anteile der Modifikationen eine Strukturierung der freigelegten Oberfläche des Spendersubstrats darstellen bzw. bewirken. Durch die genannte Ausführungsform wird die Oberflächenstruktur der freigelegten Oberfläche des Spendersubstrats aufbereitet, insbesondere geglättet, insbesondere mittels Polieren geglättet.

Weiterhin wird die freigelegte Oberfläche des Spendersubstrats nach dem Glätten, insbesondere Polieren, gereinigt. Die Reinigung erfolgt hierbei bevorzugt unter Verwendung einer fließfähigen Substanz, insbesondere einer Flüssigkeit oder einem Gas. Bevorzugt umfasst die Reinigung die Entfernung von losen Partikeln von der freigelegten Oberfläche.

Es wird des Weiteren ein Verfahren zum Aufbereiten einer Festkörperschicht angegeben. Dieses nicht zur Erfindung gehörende Verfahren zum Aufbereiten einer Festkörperschicht umfasst dabei bevorzugt mindestens die Schritte des Bereitstellens einer Mehrschichtanordnung, insbesondere hergestellt gemäß einem zuvor beschriebenen Verfahren, aufweisend ein Trägersubstrat, mit einer daran angebondeten Festkörperschicht, wobei die Festkörperschicht eine freiliegende Oberfläche mit einer definierten Oberflächenstruktur aufweist, wobei die definierte Oberflächenstruktur zumindest abschnittsweise aus einer mittels einem Riss bewirkten Abtrennung von einem Spendersubstrat resultiert, des Weiterverarbeitens, insbesondere Processing in einer weiteren Anlage oder Prozesskette, insbesondere Polieren oder Beschichten oder Strukturieren, insbesondere mittels spanender oder chemischer, z.B. ätzender Verfahren zur Chipherstellung, oder Zerteilen oder Epitaxieren oder Reinigen, insbesondere mittels Plasma, der an dem Trägersubstrat angeordneten Festkörperschicht, und des Trennens der Festkörperschicht von dem Trägersubstrat durch eine Zerstörung der Bondingschicht.

Diese Lösung ist vorteilhaft, da die Festkörperschicht auf dem Trägersubstrat bearbeitet werden kann und ohne eine Zerstörung des Trägersubstrats von dem Trägersubstrat entfernbar ist. Es ergeben sich dadurch erhebliche Materialeinsparungen, da das nicht zerstörte Trägersubstrat wiederverwendet werden kann. Somit kann eine nach dem Verfahren gemäß den Ansprüchen 1 bis 9 hergestellte Mehrschichtanordnung zur Festkörperaufbereitung in einer weiteren Fabrik oder einer weiteren Prozesskette verwendet bzw. aufbereitet werden.

Weitere bevorzugte Ausführungsformen sind Gegenstand der nachfolgenden Beschreibungsteile.

Die Bondingschicht wird gemäß einer bevorzugten Ausführungsform der vorliegenden Erfindung mit Strahlung oder einer fließfähigen Substanz beaufschlagt und zersetzt sich infolge der Beaufschlagung, wobei die Strahlung bevorzugt Laserstrahlung, insbesondere eines fs-LASERs, ist. Diese Lösung ist vorteilhaft, da es hierdurch möglich ist die Festkörperschicht ohne eine mechanische Belastung oder mit einer nur sehr geringen mechanischen Belastung von dem Trägersubstrat zu trennen.

Weiterhin wird die Verwendung eines Trägersubstrats zum Bereitstellen und/oder Bearbeiten einer Vielzahl an Festkörperschichten beschrieben. Diese Verwendung des Trägersubstrats umfasst dabei bevorzugt, dass die Festkörperschichten nacheinander von dem Trägersubstrat aufgenommen werden, wobei das Trägersubstrat jeweils mittels mindestens einer Bondingschicht mit der jeweiligen Festkörperschicht verbunden ist, wobei die Festkörperschicht nach der Bearbeitung und/oder zu ihrer Bereitstellung von dem Trägersubstrat durch Zerstörung der Bondingschicht abgelöst wird, wobei nach dem Ablösen der Festkörperschicht und vor der Anbringung einer weiteren Festkörperschicht eine Aufbereitung, insbesondere Polieren, des Trägersubstrats bewirkt wird. Die Oberflächenstruktur der freiliegenden Oberfläche der Festkörperschicht weist neben der infolge des Risses beim Abtrennen von dem Spendersubstrat geformten Anteile ebenfalls weitere Anteile auf, die durch die Modifikationen strukturiert sind.

Diese Lösung ist vorteilhaft, da durch die mehrfache Verwendung eines oder mehrerer Trägersubstrats/e die jeweilige Festkörperschicht derart stabil gehalten wird, dass sie z.B. spanend bearbeitet werden kann, sowie erhebliche Materialeinsparungen bewirkt werden. Weitere bevorzugte Ausführungsformen sind Gegenstand der nachfolgenden Beschreibungsteile.

Das Trägersubstrat ist gemäß einer weiteren bevorzugten Ausführungsform der vorliegenden Erfindung bevorzugt scheibenartig, insbesondere mit zwei zueinander parallelen und ebenen Oberflächen, ausgebildet und/oder weist eine Dicke von weniger als 800 µm auf und die Festkörperschicht weist gemäß einer weiteren bevorzugten Ausführungsform der vorliegenden Erfindung eine Dicke zwischen 10 µm und 150 µm, insbesondere zwischen 20 µm und 60 µm, auf. Besonders bevorzugt beträgt die Gesamtdicke des Trägersubstrats mit daran angebondeter Festkörperschicht bevorzugt weniger als 900 µm. Diese Lösung ist vorteilhaft, da eine Mehrschichtanordnung bereitgestellt wird, die in die Prozesse einer Waferverarbeitungsfabrik eingespeist werden könne, ohne dass die Prozesse der Waferverarbeitungsfabrik signifikant verändert werden müssen, und gegenüber den bestehenden Prozesse wird deutlich weniger Material verbraucht.

Das Spendersubstrat bzw. der Festkörper bzw. das Werkstück weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist das Spendersubstrat eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann das Spendersubstrat eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Das Spendersubstrat weist somit bevorzugt ein Halbleitermaterial oder ein Keramikmaterial auf bzw. besonders bevorzugt besteht das Spendersubstrat aus mindestens einem Halbleitermaterial oder einem Keramikmaterial. Es ist weiterhin denkbar, dass das Spendersubstrat ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7). Es ist zusätzlich oder alternativ denkbar, dass das Spendersubstrat eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können. Bevorzugt bestehen das Spendersubstrat und das Trägersubstrat aus dem gleichen Material. Alternativ ist jedoch ebenfalls denkbar, dass das Spendersubstrat und das Trägersubstrat aus verschiedenen Materialien bestehen. Das Trägersubstrat kann aus den bzgl. dem Spendersubstrat genannten Materialen bestehen oder diese aufweisen.

Gemäß einer weiteren bevorzugten Ausführungsform der vorliegenden Erfindung wird mittels der Modifikationen mehr als 5%, insbesondere mehr als 10% oder mehr als 20% oder mehr als 30% oder mehr als 40% oder mehr als 50% oder mehr als 60% oder mehr als 70% oder mehr als 80% oder mehr als 90% oder mehr als 95%, des im Verlauf des Risses ausgebildeten Kristallgitters verändert, insbesondere beschädigt. Diese Ausführungsform ist vorteilhaft, da z.B. durch die Laserbeaufschlagung das Kristallgitter derart verändert werden kann bzw. derart Defekte, insbesondere Mikrorisse, erzeugt werden können, dass die zum Abtrennen der Festkörperschicht von dem Festkörper bzw. dem Spendersubstrat erforderlichen Kräfte eingestellt werden können. Es ist somit im Sinne der vorliegenden Erfindung möglich, dass die Kristallstruktur im Bereich des Rissverlaufs derart mittels Laserstrahlung modifiziert bzw. beschädigt wird, dass sich die Festkörperschicht infolge der Laserbehandlung vom Spendersubstrat ablöst bzw. abgetrennt wird.

Die Patentanmeldungen WO 2015/052220 A1, DE 10 2013 016682 A1, DE 10 2015 000451 A1 und DE 10 2014 013107 A1 offenbaren eine Modifikationserzeugung in einem Festkörper mittels LASER-Strahlen. WO 2009/061353 A2 und WO 2010/072675 A2 offenbaren die Abtrennung von Festkörperschichten mittel Risserzeugung und Rissausbreitung.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Lösungen dargestellt sind. Bauteile oder Elemente der erfindungsgemäßen Lösungen, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigt:
Fig. 1 schematisch ein Verfahren zum Erzeugen einer Mehrschichtanordnung; und
Fig. 2 schematisch die Aufbereitung einer Festkörperschicht mit Hilfe eines Trägersubstrates.

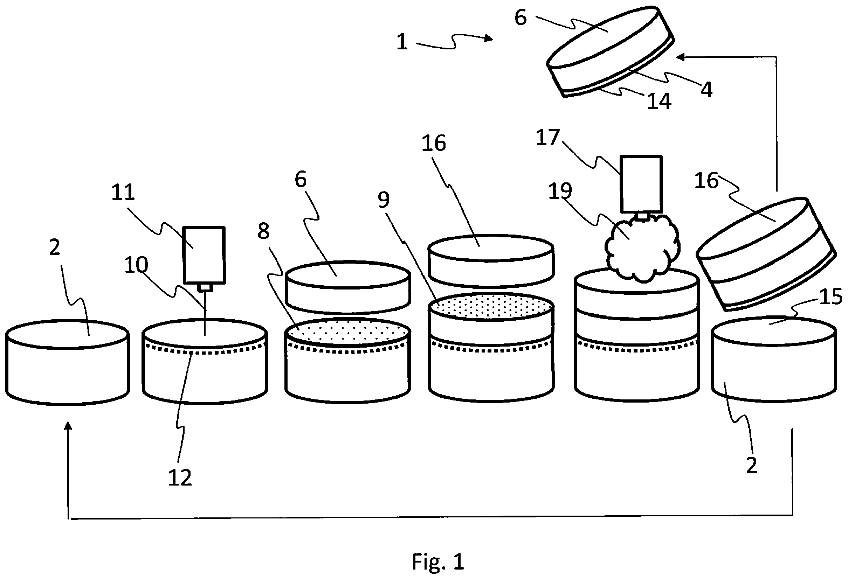

In Fig. 1 sind schematisch mehrere Zustände eines Verfahrens zum Herstellen einer Mehrschichtanordnung 1 gezeigt. Die erste Teildarstellung zeigt ein Spendersubstrat 2, dessen Oberfläche, an der in einem weiteren Schritt ein Trägersubstrat 6, bevorzugt aus GaAs, angebondet wird, bevorzugt poliert und gereinigt ist. Das Spendersubstrat 2 kann hierbei bevorzugt ein Ingot oder ein dicker Wafer sein.

In der zweiten Teildarstellung ist eine Strahlungsquelle, insbesondere eine LASER-Einrichtung 11, gezeigt, die Strahlen, insbesondere einen oder mehrere LASER-Strahlen 10, emittiert, durch den/die im Inneren des Spendersubstrats 2, d.h. bevorzugt beabstandet zu allen äußeren Oberflächen des Spendersubstrats 2, Modifikationen 12, insbesondere in einer Ebene, erzeugt werden.

In der nächsten Teildarstellung wird durch das Bezugszeichen 8 eine Bondingschicht gekennzeichnet, die zum stoffschlüssigen Fixieren des Trägersubstrats 6 an dem Spendersubstrat 2 dient. Es ist hierbei z.B. denkbar, dass die Bondingschicht 8 aus einem Kleber, insbesondere einem lichtabsorbierenden Kleber, besteht oder durch die lokale Verflüssigung des Trägersubstrats 6 und/oder des Spendersubstrats 2, insbesondere infolge einer Hitzebehandlung, erzeugt wird. Bevorzugt besteht die Bondingschicht 8 jedoch aus einem Polymermaterial bzw. weist besonders bevorzugt ein Polymermaterial auf.

Die vierte Teildarstellung zeigt eine Spannungserzeugungsschicht 16, die im gezeigten Beispiel zunächst erzeugt wurde, um dann am dem Trägersubstrat 6 angeordnet zu werden. Das Trägersubstrat 6 wird bevorzugt vor der Anbringung der Spannungserzeugungsschicht 16 an dem Trägersubstrat 6 oder vor der Erzeugung der Spannungserzeugungsschicht 16 auf dem Trägersubstrat 6 mit einer Opferschicht 9 beschichtet. Die Opferschicht 9 kann hierbei z.B. als Haftvermittler oder zum leichteren Entfernen der Spannungserzeugungsschicht 16 vorgesehen sein. Bevorzugt weist die Spannungserzeugungsschicht 16 eine Dicke auf, die um ein Vielfaches größer ist als die Dicke der Opferschicht 9.

Gemäß der nächsten Teildarstellung ist eine Temperierungseinrichtung 17 vorgesehen, die ein Kühlmittel 19, insbesondere flüssiger Stickstoff, ausgibt. Das Kühlmittel 19 bewirkt dabei eine sehr schnelle Abkühlung der Spannungserzeugungsschicht 16 auf eine Temperatur unterhalb der Glasübergangstemperatur des Materials der Spannungserzeugungsschicht 16. Durch das Abkühlen der Spannungserzeugungsschicht 16 zieht sich die Spannungserzeugungsschicht 16 zusammen und leitet dadurch Spannungen in das Spendersubstrat 2 ein. Wenn die Spannungen eine kritische Intensität übersteigen, dann bildet sich ein Riss im Bereich der Modifikationen 12 aus und trennt dadurch die Festkörperschicht 4 von dem Spendersubstrat 2 ab, wodurch zum einen eine Oberfläche 15 des Spendersubstrats 2 freigelegt wird und wodurch zum anderen eine Oberfläche 14 der Festkörperschicht 4 freigelegt wird.

Bevorzugt wird nach dem Abtrennend der Festkörperschicht 4 von dem Spendersubstrat 2 gemäß dem oberen Pfeil die Spannungserzeugungsschicht 16 und bevorzugt ebenfalls die Opferschicht 9 von dem Trägersubstrat 6 entfernt, woraus die erfindungsgemäße Mehrschichtanordnung 1 resultiert. Das Spendersubstrat 2 wird gemäß dem unteren Pfeil wieder als Spendersubstrat 2 eingesetzt bzw. das beschriebene Verfahren beginnt erneut. Das Spendersubstrat 2 wird dazu bevorzugt aufbereitet, insbesondere wird die freigelegte Oberfläche 15 bevorzugt behandelt, insbesondere geglättet, insbesondere poliert.

Das Trägersubstrat 6 dient zum Abdünnen eines Spendersubstrats 2 und als Stabilisator beim Bearbeiten der jeweiligen Festkörperschicht 4.

Die vorliegende Erfindung bezieht sich somit auf ein Verfahren zum Herstellen einer Mehrschichtanordnung 1. Das erfindungsgemäße Verfahren umfasst dabei bevorzugt mindestens die Schritte: Bereitstellen eines Spendersubstrats 2 zum Abtrennen einer Festkörperschicht 4, insbesondere eines Wafers; Erzeugen von Modifikationen 12, insbesondere mittels LASER-Strahlen 10, in dem Spendersubstrat 2 zum Vorgeben eines Rissverlaufs; Bereitstellen eines Trägersubstrats 6 zum Aufnehmen der Festkörperschicht 4; Anbonden des Trägersubstrats 6 mittels einer Bondingschicht 8 an dem Spendersubstrat 2, wobei das Trägersubstrat 6 zur Erhöhung der mechanischen Festigkeit der abzutrennenden Festkörperschicht 4 für die Weiterverarbeitung vorgesehen ist, Anordnen oder Erzeugen einer Spannungserzeugungsschicht 16 an dem Trägersubstrat 6, Thermisches Beaufschlagen der Spannungserzeugungsschicht 16 zum Erzeugen von Spannungen in dem Spendersubstrat 2, wobei durch die Spannungserzeugung ein Riss ausgelöst wird, der sich entlang des vorgegebenen Rissverlaufs zum Abtrennen der Festkörperschicht 4 vom Spendersubstrat 2 ausbreitet, so dass sich die Festkörperschicht 4 mit dem angebondeten Trägersubstrat 6 abtrennt.

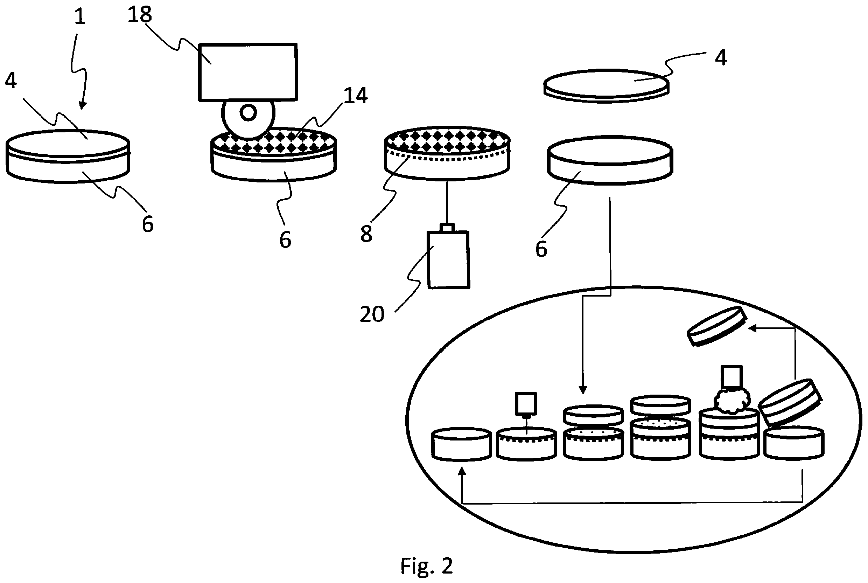

In Fig. 2 ist eine Mehrschichtanordnung 1 gezeigt, wie sie bevorzugt gemäß den Ausführungen zu Fig. 1 erzeugt wurde.

In der neben der ersten Teildarstellung gezeigten zweiten Teildarstellung ist die Mehrschichtanordnung 1 derart gegenüber einer Bearbeitungseinrichtung 18 angeordnet, dass mittels der Bearbeitungseinrichtung 18 die freigelegte Oberfläche 14 der Festkörperschicht 4 behandelt werden kann. Es ist hierbei denkbar, dass die Bearbeitungseinrichtung 18 mechanisch, insbesondere spanend, optisch, chemisch und/oder mittels Plasma, die freigelegte Oberfläche 14 behandelt.

In der dritten Teildarstellung ist eine Zersetzungseinrichtung 20 dargestellt, durch die die Bondingschicht 8 beaufschlagt, insbesondere zerstört, wird. Die Zersetzungseinrichtung 20 emittiert dazu z.B. Strahlung. Die Strahlung kann hierbei bevorzugt LASER-Strahlung oder UV-Strahlung sein. Im Falle von LASER-Strahlung wird die Strahlung bevorzugt von einem Piko- oder Femtosekunden-LASER emittiert. Alternativ ist jedoch ebenfalls denkbar, dass die Zersetzungseinrichtung 20 eine fließfähige Substanz, insbesondere ein Fluid, ausgibt, durch die die Bondingschicht aufgelöst wird. Alternativ oder zusätzlich ist denkbar, dass die Zersetzungseinrichtung 20 eine Temperatur erzeugt, durch die sich die Bondingschicht 8 zersetzt oder auflöst.

In der vierten Teildarstellung ist ein Zustand nach dem Abtrennen der Festkörperschicht 4 von dem Trägersubstrat 6 gezeigt. Das Trägersubstrat 6 wird dann bevorzugt aufbereitet, insbesondere gereinigt und/oder geglättet, insbesondere poliert.

Die elliptische Darstellung zeigt das durch die Fig.1 dargestellte Verfahren. Der Pfeil kennzeichnet hierbei, dass das freigelegte und bevorzugt aufbereitete Trägersubstrat 6 als Trägersubstrat 6 in dem in Fig. 1 gezeigten Verfahren erneut eingesetzt wird.

Die Erfindung ist vorteilhaft, da sie Materialverluste reduziert und eine Lösung zum Erzeugen äußerst, insbesondere absolut, planer dünner Festkörperschichten 4, insbesondere Nutzwafer, liefert. Die so erzeugten Festkörperschichten 4 bzw. Nutzwafer weisen somit eine äußerst ebene Rückseite auf, wodurch sie sich insbesondere für eine 3D-Integration eignen, da sie z.B. keinen Warp und bevorzugt ebenfalls keine sonstigen Verformungen aufweisen.

**Bezugszeichenliste**

| | | | |
|---|---|---|---|
| 1 | Mehrschichtanordnung | 4 | Festkörperschicht |
| 2 | Spendersubstrat | 6 | Trägersubstrat |
| 8 | Bondingschicht | 15 | freigelegte Oberfläche des Spendersubstrats |
| 9 | Opferschicht | | |
| 10 | LASER-Strahlen | 16 | Spannungserzeugungsschicht |
| 11 | LASER-Einrichtung | 17 | Temperierungseinrichtung |
| 12 | Modifikationen | 18 | Bearbeitungseinrichtung |
| 14 | freigelegte Oberfläche der Festkörperschicht | 19 | Kühlmittel |
| | | 20 | Zersetzungseinrichtung |

## Patentansprüche

1. Verfahren zum Herstellen einer Mehrschichtanordnung (1),
mindestens umfassend die Schritte:
- Bereitstellen eines Spendersubstrats (2) zum Abtrennen einer Festkörperschicht (4), insbesondere eines Wafers;
- Erzeugen von Modifikationen (12), insbesondere mittels LASER-Strahlen (10), in dem Spendersubstrat (2) zum Vorgeben eines Rissverlaufs;
- Bereitstellen eines Trägersubstrats (6) zum Aufnehmen der Festkörperschicht (4);
- Anbonden des Trägersubstrats (6) mittels einer Bondingschicht (8) an dem Spendersubstrat (2), wobei das Trägersubstrat (6) zur Erhöhung der mechanischen Festigkeit der abzutrennenden Festkörperschicht (4) für die Weiterverarbeitung vorgesehen ist,
- Anordnen oder Erzeugen einer Spannungserzeugungsschicht (16) an dem Trägersubstrat (6);
- Thermisches Beaufschlagen der Spannungserzeugungsschicht (16) zum Erzeugen von Spannungen in dem Spendersubstrat (2), wobei durch die Spannungserzeugung ein Riss ausgelöst wird, der sich entlang des vorgegebenen Rissverlaufs zum Abtrennen der Festkörperschicht (4) vom Spendersubstrat (2) ausbreitet, so dass sich die Festkörperschicht (4) mit dem angebondeten Trägersubstrat (6) abtrennt.

2. Verfahren nach Anspruch 1
**dadurch gekennzeichnet, dass**
die Bondingschicht (8) die Festkörperschicht (4) und das Trägersubstrat (6) stoffschlüssig miteinander verbindet und mittels Strahlung einer Strahlungsquelle, insbesondere LASER-Strahlen (10) oder UV-Strahlung, oder einer fließfähigen Substanz, insbesondere einer flüssigen Lösung, zerstörbar ist.

3. Verfahren nach Anspruch 1 oder 2
**dadurch gekennzeichnet, dass**
nach dem Abtrennen der Festkörperschicht (4) von dem Spendersubstrat (2) die Spannungserzeugungsschicht (16) von dem Trägersubstrat (6) entfernt wird und/oder
eine Materialschicht, insbesondere epitaktisch, auf der Festkörperschicht erzeugt wird, wobei vor der Erzeugung der Materialschicht eine strukturelle Schwächung des Trägersubstrats (6) und/oder der Festkörperschicht (4) bewirkt wird.

4. Verfahren nach einem der vorangegangenen Ansprüche,
**dadurch gekennzeichnet, dass**
das bereitgestellte Trägersubstrat (6) mehrfach zum Erzeugen einer Mehrschichtanordnung (1) verwendet wird, wobei die Festkörperschicht (4) vor der erneuten Bereitstellung von dem Trägersubstrat (6) entfernt wird und das Trägersubstrat (6) vor der erneuten Bereitstellung aufbereitet, insbesondere poliert, wird.

5. Verfahren nach einem der vorangegangenen Ansprüche,
**dadurch gekennzeichnet, dass**
vor dem Anordnen oder Erzeugen einer Spannungserzeugungsschicht (16) an dem Trägersubstrat (6) eine Opferschicht (9) auf dem Trägersubstrat (6) angeordnet oder erzeugt wird, wobei die Spannungserzeugungsschicht (16) an der Opferschicht (9) angeordnet oder erzeugt wird.

6. Verfahren nach einem der vorangegangenen Ansprüche,
**dadurch gekennzeichnet, dass**
die Spannungserzeugungsschicht (16) ein Polymer, insbesondere Polydimethylsiloxan (PDMS), aufweist oder daraus besteht, wobei die thermische Beaufschlagung derart erfolgt, dass das Polymer einen Glasübergang erfährt, wobei die Spannungserzeugungsschicht (16), insbesondere mittels flüssigem Stickstoff, auf eine Temperatur unterhalb der Raumtemperatur oder unterhalb von 0°C oder unterhalb von -50°C oder unterhalb von - 100°C oder unterhalb von -110°C, insbesondere auf eine Temperatur unterhalb der Glasübergangstemperatur der Spannungserzeugungsschicht (16), temperiert wird.

7. Verfahren nach einem der vorangegangenen Ansprüche,
**dadurch gekennzeichnet, dass**
die Modifikationen (12) lokale Risse im Kristallgitter und/oder in eine andere Phase überführte Materialanteile sind und/oder
die Modifikationen (12) mittels über eine äußere Oberfläche des Spendersubstrats, insbesondere an der das Trägersubstrat (6) angeordnet wird, eingeleitete LASER-Strahlen (10) einer als LASER-Einrichtung (11) ausgebildeten Strahlungsquelle erzeugt werden.

8. Verfahren nach Anspruch 7,
**dadurch gekennzeichnet, dass**
die LASER-Einrichtung (11) zum Bereitstellen der in das Spendersubstrat (2) einzubringenden LASER-Strahlen (10) derart konfiguriert ist, dass die von ihr ausgestrahlten LASER-Strahlen (10) die Modifikationen (12) an vorbestimmten Orten innerhalb des Spendersubstrats (2) erzeugen, wobei die LASER-Einrichtung (11) derart eingestellt wird, dass die von ihr ausgestrahlten LASER-Strahlen (10) zum Erzeugen der Modifikationen (12) auf eine definierte Tiefe von weniger als 200µm, bevorzugt von weniger als 150µm und weiter bevorzugt von weniger als 100µm und besonders bevorzugt von weniger als 60µm oder von weniger als 50µm in das Spendersubstrat (2) eindringen, wobei die LASER-Einrichtung (11) eine Pulsdauer von unter 10 ps bevorzugt von unter 1 ps und besonders bevorzugt von unter 500 fs aufweist.

9. Verfahren nach einem der vorangegangenen Ansprüche 7 oder 8,
**dadurch gekennzeichnet, dass**
die LASER-Einrichtung (11) einen Femtosekunden-LASER (fs-LASER) umfasst und die Energie der LASER-Strahlen (10) des fs-LASER derart gewählt wird, dass die Schädigungsausbreitung einer jeden Modifikation (12) in dem Spendersubstrat kleiner als 3 mal die Rayleighlänge, bevorzugt kleiner als die Rayleighlänge und besonders bevorzugt kleiner ein Drittel mal die Rayleighlänge ist
und/oder
die Wellenlänge der LASER-Strahlen (10) des fs-LASER derart gewählt wird, dass die Absorption des Spendersubstrats (2) kleiner als 10cm⁻¹ und bevorzugt kleiner als 1cm⁻¹ und besonders bevorzugt kleiner als 0,1cm⁻¹ ist
und/oder
sich die einzelnen Modifikationen (12) jeweils in Folge einer von dem fs-LASER bewirkten multi-photonen Anregung ergeben.

## Claims

1. Process of producing a multilayer arrangement (1),
at least comprising the steps of:
- providing a donor substrate (2) in order to separate off a solid-state layer (4), especially a wafer;
- generating modifications (12), especially by means of LASER beams (10), in the donor substrate (2) to define a crack progression;
- providing a carrier substrate (6) in order to accommodate the solid-state layer (4);
- bonding the carrier substrate (6) by means of a bonding layer (8) to the donor substrate (2), wherein the carrier substrate (6) is provided in order to increase the mechanical strength of the solid-state layer (4) to be separated off for further processing,
- disposing or generating a stress generation layer (16) on the carrier substrate (6);
- subjecting the stress generation layer (16) to thermal stress in order to generate stresses in the donor substrate (2), wherein the generation of stress triggers a crack that propagates along the defined crack progression in order to separate the solid-state layer (4) from the donor substrate (2), such that the solid-state layer (4) separates off with the bonded carrier substrate (6).

2. Process according to Claim 1,
**characterized in that**
the bonding layer (8) cohesively bonds the solid-state layer (4) and the carrier substrate (6) to one another and is destructible by means of radiation from a radiation source, especially LASER beams (10) or UV radiation, or a free-flowing substance, especially a fluid solution.

3. Process according to Claim 1 or 2,
**characterized in that**
the separating of the solid-state layer (4) from the donor substrate (2) is followed by removal of the stress generation layer (16) from the carrier substrate (6) and/or
a material layer is generated, especially epitaxially, on the solid-state layer, wherein the generation of the material layer is preceded by bringing about structural weakening of the carrier substrate (6) and/or the solid-state layer (4).

4. Process according to any of the preceding claims,
**characterized in that**
the carrier substrate (6) provided is used repeatedly in order to generate a multilayer arrangement (1), wherein the solid-state layer (4) is removed from the carrier substrate (6) prior to the next provision and the carrier substrate (6) is prepared, especially polished, prior to the next provision.

5. Process according to any of the preceding claims,
**characterized in that**
the arrangement or generation of a stress generation layer (16) on the carrier substrate (6) is preceded by arrangement or generation of a sacrificial layer (9) on the carrier substrate (6), wherein the stress generation layer (16) is arranged or generated atop the sacrificial layer (9).

6. Process according to any of the preceding claims,
**characterized in that**
the stress generation layer (16) includes or consists of a polymer, especially polydimethylsiloxane (PDMS), wherein the thermal stress is implemented **in that** the polymer undergoes a glass transition, wherein the stress generation layer (16) is brought, especially by means of liquid nitrogen, to a temperature below room temperature or below 0°C or below - 50°C or below -100°C or below -110°C, especially to a temperature below the glass transition temperature of the stress generation layer (16).

7. Process according to any of the preceding claims,
**characterized in that**
the modifications (12) are local cracks in the crystal lattice and/or material components that have been transferred into another phase and/or
the modifications (12) are generated by means of LASER beams (10) from a radiation source in the form of a LASER device (11) that have been introduced via an outer surface of the donor substrate, especially that on which the carrier substrate (6) is disposed.

8. Process according to Claim 7,
**characterized in that**
the LASER device (11) is configured in order to provide the LASER beams (10) to be introduced into the donor substrate (2) in such a way that the LASER beams (10) that it emits generate the modifications (12) at predetermined sites within the donor substrate (2), wherein the LASER device (11) is adjusted such that the LASER beams (10) that it emits in order to generate the modifications (12) penetrate into the donor substrate (2) to a defined depth of less than 200 µm, preferably of less than 150 µm and further preferably of less than 100 µm and especially preferably of less than 60 µm or of less than 50 µm, wherein the LASER device (11) has a pulse duration of less than 10 ps, preferably of less than 1 ps and more preferably of less than 500 fs.

9. Process according to either of the preceding Claims 7 and 8,
**characterized in that**
the LASER device (11) comprises a femtosecond LASER (fs LASER) and energy from the LASER beams (10) of the fs LASER is chosen such that the propagation of damage of each modification (12) in the donor substrate is less than 3 times the Rayleigh length, preferably less than the Rayleigh length and more preferably less than one third of the Rayleigh length,
and/or
the wavelength of the LASER beams (10) of the fs LASER is chosen such that the absorption of the donor substrate (2) is less than 10 cm⁻¹ and preferably less than 1 cm⁻¹ and especially preferably less than 0.1 cm⁻¹,
and/or
the individual modifications (12) each result from a multiphoton excitation brought about by the fs LASER.

## Revendications

1. Procédé de production d'un agencement (1) stratifié,
comprenant au moins les stades :
- on se procure un substrat (2) sacrificiel pour la séparation d'une couche (4) semi-conductrice, notamment d'une plaquette ;
- on produit des modifications (12), notamment au moyen d'un faisceau (10) laser, dans le substrat (2) sacrificiel pour prescrire un tracé de fissure ;
- on se procure un substrat (6) de support de réception de la couche (4) semi-conductrice ;
- on relie le substrat (6) de support au moyen d'une couche (8) de liaison au substrat (2) sacrificiel, le substrat (6) de support étant prévu pour augmenter la résistance mécanique de la couche (4) semi-conductrice à séparer lors du traitement ultérieur ;
- on met ou on produit une couche (16) de production de contraintes sur le substrat (6) de support ;
- on sollicite thermiquement la couche (16) de production de contraintes pour la production de contraintes dans le substrat (2) sacrificiel, dans lequel, par la production de contraintes, on déclenche une fissure, qui se propage le long du tracé donné à l'avance de fissure pour séparer la couche (4) semi-conductrice du substrat (2) sacrificiel, de manière à séparer la couche (4) semi-conductrice avec le substrat (6) de support qui y est relié.

2. Procédé suivant la revendication 1,
**caractérisé en ce que**
la couche (8) de liaison relie entre eux à coopération de matière la couche (4) semi-conductrice et le substrat (6) de support et peut être détruite au moyen d'un rayonnement d'une source de rayonnement, notamment d'un faisceau (10) LASER ou d'un rayonnement UV, ou d'une substance susceptible de s'écouler, notamment d'une solution liquide.

3. Procédé suivant la revendication 1 ou 2,
**caractérisé en ce que**
après la séparation de la couche (4) semi-conductrice du substrat (2) sacrificiel, on élimine la couche (16) de production de contraintes du substrat (6) de support et/ou on produit une couche de matière, notamment par épitaxie, sur la couche semi-conductrice, un affaiblissement structurel du substrat (6) de support et/ou de la couche (4) semi-conductrice étant provoqué avant la production de la couche de matière.

4. Procédé suivant l'une des revendications précédentes,
**caractérisé en ce que**
on utilise le substrat (6) de support, que l'on s'est procuré, plusieurs fois pour la production d'un agencement (1) stratifié, la couche (4) semi-conductrice étant, avant la remise à disposition du substrat (6) de support, retirée et le substrat (6) de support étant traité, notamment poli, avant sa remise à disposition.

5. Procédé suivant l'une des revendications précédentes,
**caractérisé en ce que**
avant de mettre ou de produire une couche (16) de production de contraintes sur le substrat (6) de support, on met ou on produit une couche (9) sacrificielle sur le substrat (6) de support, la couche (16) de production de contraintes étant mise ou produite sur la couche (9) sacrificielle.

6. Procédé suivant l'une des revendications précédentes,
**caractérisé en ce que**
la couche (16) de production de contraintes a un polymère, notamment du polydiméthylsiloxane (PDMS), ou en est constituée, la sollicitation thermique s'effectuant de manière à ce que le polymère subisse un passage à l'état vitreux, la couche (16) de production de contraintes étant, notamment au moyen d'azote liquide, mise à une température en dessous de la température ambiante ou en dessous de 0°C ou en dessous de -50°C ou en dessous de -100°C ou en dessous de -110°C, notamment à une température en dessous du point de passage à l'état vitreux de la couche (16) de production de contraintes.

7. Procédé suivant l'une des revendications précédentes,
**caractérisé en ce que**
les modifications (12) sont des fissures locales du réseau cristallin et/ou dans des parties du matériau passées dans un autre phase et/ou
on produit les modifications (12) au moyen d'un faisceau (10) LASER d'une source de rayonnement constituée en dispositif (11) LASER, envoyé sur une surface extérieure du substrat sacrificiel, notamment sur laquelle est disposé le substrat (6) de support.

8. Procédé suivant la revendication 7,
**caractérisé en ce que**
le dispositif (11) LASER pour procurer le faisceau (10) LASER, à introduire dans le substrat (2) sacrificiel, est configuré de manière à ce que le faisceau LASER qu'il émet produise les modifications (12) en des emplacements déterminés à l'avance au sein du substrat (2) sacrificiel, le dispositif (11) LASER étant réglé de manière à ce que le faisceau (10) LASER qu'il émet pénètre, pour la production des modifications (12), jusqu'à une profondeur définie de moins de 200 µm, de préférence de moins de 150 µm et, d'une manière encore plus préférée, de moins de 100 µm et, d'une manière particulièrement préférée, de moins de 60 µm ou de moins de 50 µm dans le substrat (2) sacrificiel, le dispositif (11) LASER ayant une durée des impulsions inférieure à 10 ps, de préférence inférieure à 1 ps, et, d'une manière particulièrement préférée, inférieure à 500 fs.

9. Procédé suivant la revendication 7 ou 8,
**caractérisé en ce que**
le dispositif (11) LASER comprend un LASER à femtoseconde (LASER-fs) et on choisit l'énergie du faisceau (10) LASER du LASER-fs, de manière à ce que la propagation du dommage de chaque modification dans le substrat sacrificiel soit plus petite que 3 fois la longueur de Rayleigh, de préférence plus petite que la longueur de Rayleigh et, d'une manière particulièrement préférée, plus petite qu'un tiers de la longueur de Rayleigh
et/ou
on choisit la longueur d'onde du faisceau (10) LASER du LASER-fs, de manière à ce que l'absorption du substrat (2) sacrificiel soit plus petite que 10 cm⁻¹ et de préférence plus petite que 1 cm⁻¹ et, d'une manière particulièrement préférée, plus petite que 0,1 cm⁻¹
et/ou
les diverses modifications (12) proviennent de l'excitation de photons multiples provoqués par le LASER-fs.
